# EUROPEAN PATENT APPLICATION

(11) **EP 2 034 517 A1**
(43) Date of publication of application: **11.03.2009**
(21) Application number: 07744793.6
(22) Date of filing: 06.06.2007
(51) Int. Cl.: H01L 21/3205, H01L 21/768, H01L 23/52, H01L 23/522

(54) **SEMICONDUCTOR DEVICE AND SEMICONDUCTOR DEVICE MANUFACTURING METHOD**

(30) Priority: 23.06.2006 JP 2006174429
(71) Applicant: Tokyo Electron Limited, Tokyo 107-6325 (JP)
(72) Inventor: HORIGOME, Masahiro, c/o Tokyo Electron Limited, Nirasaki-shi Yamanashi 407-0192 (JP)
(74) Representative: Manitz, Finsterwald & Partner GbR
(86) International application number: PCT/JP2007/061450
(87) International publication number: WO 2007/148535

(57) **Abstract**

A semiconductor device of the present invention is provided with a substrate; an insulating film made of a fluorine-containing carbon film and formed on the substrate; a copper wiring buried in the insulating film; and a barrier film formed between the insulating film and the copper wiring. The barrier film includes a first film made of titanium for suppressing a diffusion of fluorine, and a second film made of tantalum for suppressing a diffusion of copper and formed between the first film and the copper wiring.

## Description

### [Technical Field]

The present invention relates to a semiconductor device and a manufacturing method thereof, in which a fluorine-containing carbon film is used as an insulating film, for example, an interlayer insulating film, and a copper wiring is formed on the insulating film.

### [Background Art]

Recently, to achieve higher integration of a semiconductor device, a multilayer wiring structure has been employed. However, with the progression of miniaturization and high integration of the semiconductor device, a delay of an electric signal passing through a wiring (i.e., a wiring delay) has become a problem which impedes a realization of a high speed operation of the device. The wiring delay is proportional to the product of a wiring resistance and an inter-wiring capacitance.

In order to shorten the wiring delay, it is required to lower a resistance of an electrode wiring material and a dielectric constant of an interlayer insulating film for insulating each layer. For this purpose, copper (Cu) having a lower resistance has been desirably used as the wiring material.

However, since the copper is an easily diffusible element, it has been known that an insulating property of the interlayer insulating film is deteriorated due to the diffusion of the copper. Therefore, it is necessary to interpose between a copper wiring and the interlayer insulating film, a barrier film for preventing the diffusion of the copper.

Disclosed in Japanese Patent Laid-open Publication No. 2005-109138 is tantalum (Ta) or tantalum nitride (TaN) as a barrier film for preventing the diffusion of the copper.

Meanwhile, in order to lower the dielectric constant, a film (a SiCOH film) containing silicon, carbon, oxygen and hydrogen attracts attention as the interlayer insulating film. Further, the inventor of the present invention has considered adopting a fluorine-containing carbon film (fluorocarbon film) which is a compound of carbon (C) and fluorine (F) and has a dielectric constant lower than that of the SiCOH film.

However, the fluorine-containing carbon film has a characteristic that the fluorine is easily separated therefrom by heating.

After completing the manufacture of the semiconductor device, for example, a heat treatment of about 400°C is performed on the semiconductor device to stabilize the crystal defects therein. In case that a fluorine-containing carbon film is used as an insulating film and a tantalum film is used as a barrier film for suppressing the copper from being diffused into the insulating film from the copper wiring, the fluorine is diffused into the tantalum film from the fluorine-containing carbon film due to the heat treatment, so that tantalum fluoride (TaF₅) is generated. Since the tantalum fluoride has a high vapor pressure, it is evaporated during the heat treatment. For this reason, the density of the tantalum film is reduced and the barrier property thereof against the copper is deteriorated. Further, sheet resistance is increased, and the adhesivity between the fluorine-containing carbon film and the tantalum film is also decreased.

Accordingly, there is requested a barrier film which is a thin film and capable of preventing the diffusion of copper and fluorine.

Japanese Patent Laid-open Publication No. 2005-302811 discloses a fluorine-containing carbon film, but it does not mention the above-mentioned problems and the means for solving the problems.

### [Disclosure of the Invention]

In view of the foregoing problem, with respect to a semiconductor device in which a fluorine-containing carbon film is used as an insulating film, for example, an interlayer insulating film, and a copper wiring is formed on the insulating film, the present invention provides a semiconductor device and a manufacturing method thereof, capable of efficiently suppressing the diffusion of fluorine and copper between the insulating film and the copper wiring.

In accordance with the present invention, there is provided a semiconductor device including: a substrate; an insulating film made of a fluorine-containing carbon film and formed on the substrate; a copper wiring buried in the insulating film; and a barrier film formed between the insulating film and the copper wiring, wherein the barrier film includes: a first film made of titanium for suppressing a diffusion of fluorine, and a second film made of tantalum for suppressing a diffusion of copper and formed between the first film and the copper wiring.

In accordance with the present invention, it is possible to efficiently suppress the diffusion of the fluorine and the copper between the insulating film and the copper wiring, and also efficiently suppress the reduction of the thickness of the barrier film.

Further, in accordance with the present invention, there is provided a manufacturing method of a semiconductor device, the method including: forming an insulating film made of a fluorine-containing carbon film on a substrate; forming a recess portion in the insulating film; forming a first film made of titanium in the recess portion; forming a second film made of tantalum on a surface of the first film; and forming a wiring made of copper on a surface of the second film.

In accordance with the present invention, it is possible to easily manufacture the semiconductor device capable of efficiently suppressing the diffusion of the fluorine and the copper between the insulating film and the copper wiring, and also capable of efficiently suppressing the reduction of the thickness of the barrier film.

### [Brief Description of the Drawings]

Figs. 1A to 1C are cross sectional views of a semiconductor device for explaining an embodiment of a manufacturing method of the semiconductor device in accordance with the present invention;
Figs. 2A to 2C are cross sectional views of the semiconductor device for explaining the embodiment of the manufacturing method of the semiconductor device in accordance with the present invention, after Fig. 1C;
Figs. 3A and 3B are cross sectional views of the semiconductor device for explaining the embodiment of the manufacturing method of the semiconductor device in accordance with the present invention, after Fig. 2C;
Fig. 4 is a schematic longitudinal cross sectional view showing an example of a manufacturing apparatus for performing the manufacturing method of the semiconductor device in accordance with the present invention;
Fig. 5 is a schematic cross sectional view of wafers 1 to 6 used in each experiment;
Fig. 6 is a characteristic diagram showing the result of the wafer 3 in Experiment 3;
Fig. 7 is a characteristic diagram showing the result of the wafer 6 in Experiment 3; and
Fig. 8A is a characteristic diagram showing the result of Experiment 4 before a heat treatment, and Fig. 8B is a characteristic diagram showing the result of Experiment 4 after a heat treatment.

### [Best Mode for Carrying out the Invention]

Hereinafter, an embodiment of a manufacturing method of a semiconductor device in accordance with the present invention will be described. Here, there will be explained a case of manufacturing a multilayer wiring structure by forming an (n+1)^{th} wiring layer on an n^{th} (n is integer of 1 or greater) wiring layer made of a metal, e.g., copper, in an insulating film on a substrate.

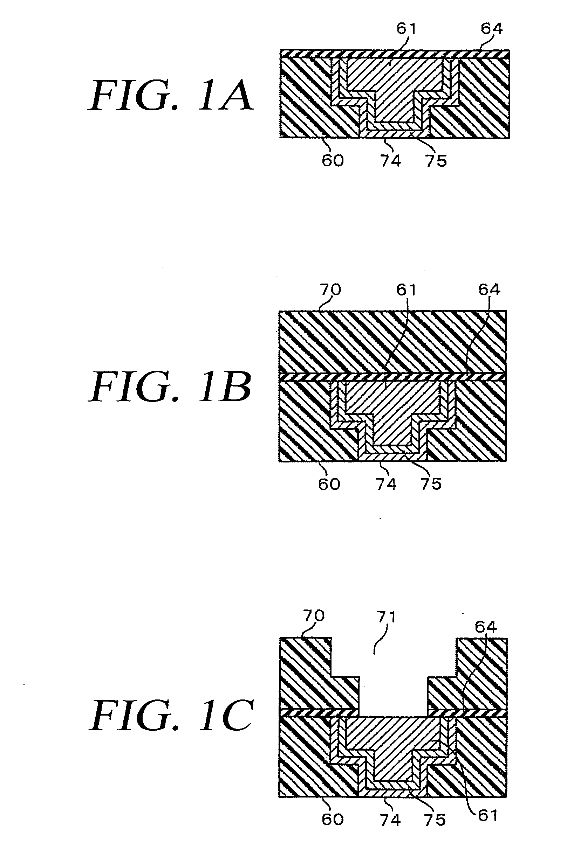

Fig. 1A illustrates a schematic cross sectional view of a substrate, for example, a semiconductor wafer (hereinafter, referred to as "wafer") W provided with a Cu wiring 61 serving as an n^{th} wiring layer in a fluorine-containing carbon film (hereinafter, referred to as "CF film") 60 serving as an insulating film. In this case, a barrier film 64 made of an insulating film such as a SiN film is formed on a surface of an n^{th} circuit layer such that copper is not diffused into an (n+1)^{th} interlayer insulating film (CF film 70), i.e., the next layer from the n^{th} Cu wiring 61.

In the present embodiment, as will be described later, film forming gas including carbon and fluorine, for example, C₅F₈ is excited into plasma state and the substrate is under plasma atmosphere. With this atmosphere, active species generated from the C₅F₈ gas is deposited on a surface of the wafer W, and as shown in Fig. 1B, an interlayer insulating film made of the CF film 70 is formed in a thickness of, e.g., 200 nm.

Then, as shown in Fig. 1C, by employing a conventional method such as a dry etching which uses a photoresist mask, a hard mask or the like, a recess portion 71 including a via hole and a trench groove in a damascene structure is formed in the CF film 70. Here, a detailed description of these processes will be omitted.

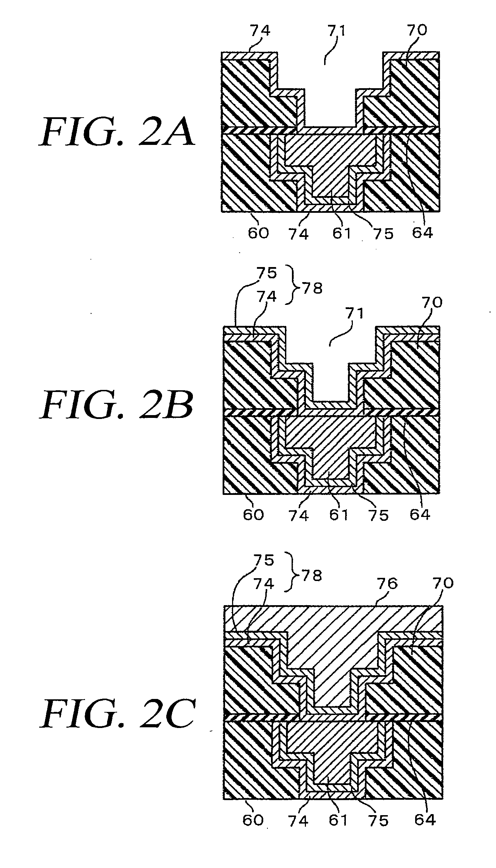

Thereafter, as shown in Fig. 2A, a Ti film 74 serving as a first film and constituting a part of a barrier film 78 is formed on a whole surface of the wafer W by, for example, a sputtering process. In this sputtering process, ions such as, e.g., Ar ions are brought into collision with a Ti target, so that titanium particles are generated and separated from the Ti target and then deposited on the surface of the wafer W (an exposed surface of the CF film 70 and a surface of the Cu wiring 61), whereby the Ti film 74 is formed thereon. As will be described later, the Ti film 74 is a film having a barrier function of suppressing fluorine in the CF film 70 from being diffused into a layer above the Ti film 74, and the barrier function can be sufficiently obtained with a film thickness of, for example, about 3 to 10 nm.

Subsequently, as shown in Fig. 2B, a Ta film 75 serving as a second film is formed on a surface of the Ti film 74. In the same manner as the Ti film 74, the Ta film 75 is formed by using a sputtering device. It is desirable that a thickness of the Ta film 75 is about 5 to 10 nm. As will be described later, the Ta film 75 is a film having a barrier function of suppressing copper in a Cu wiring 76 making contact with the Ta film 75 from being diffused into the Ti film 74. In this manner, the barrier film 78 made of the Ti film 74 and the Ta film 75 is formed.

Then, as shown in Fig. 2C, the Cu wiring 76 is buried. The Cu wiring 76 may be formed by, for example, a CVD method which uses a gas generated by vaporizing an organic material containing copper. In addition, it may be formed by employing a method of forming a seed layer of copper by an electroless plating method and then performing an electroplating by using the seed layer of copper as an electrode.

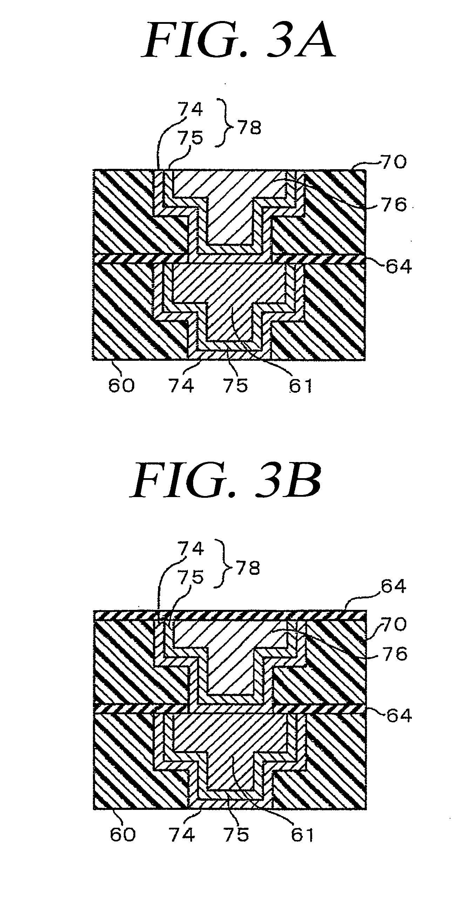

Subsequently, the Ti film 74, the Ta film 75 and the Cu wiring 76, which are formed on a top surface of the CF film 70, are removed by, for example, a polishing called a CMP (Chemical Mechanical Polishing), thereby forming the Cu wiring 76 of an (n+1)^{th} layer (see Fig. 3A). Then, in the same manner as Fig. 1A, the barrier film 64 made of an insulating film such as a SiN film is formed on the surface of the wafer W (see Fig. 3B).

Thereafter, by repeating the processes of Fig. 1B to Fig. 3B, a circuit including predetermined number of layers is formed. Further, after completing the manufacture of a desired semiconductor device (a multilayer wiring structure), for example, a heat treatment of about 400°C is performed to eliminate the crystal defects in the semiconductor device so that the physical properties thereof are stabilized.

In accordance with the above embodiment, for example, explaining with respect to the wiring structure of the (n+1)^{th} layer, the Ti film 74 serving as the first film and the Ta film 75 serving as the second film are laminated between the CF film 70 and the Cu wiring 76 and laminated in sequence from the CF film 70, thereby forming the barrier film 78. For this reason, as can be seen from experimental results to be described later, even if the resultant structure undergoes, for example, a heat treatment such as an annealing process which is performed after the manufacturing process of the semiconductor device has been completed, the fluorine is suppressed from being diffused into the Ta film 75 or the Cu wiring 76 from the CF film 70. Further, the copper is suppressed from being diffused into the Ti film 74 or the CF film 70 from the Cu wiring 76. Accordingly, the reaction among the fluorine, the tantalum and the copper due to the heat treatment is suppressed, so that the increase of sheet resistance due to the reaction among the fluorine, the tantalum and the copper can be suppressed, as can be seen from experimental results to be described later. As a result, the degradation of electrical characteristics of the semiconductor device can be suppressed. Further, since the Ti film 74 and the Ta film 75 do not incur a chemical reaction at about 400°C, they do not form an alloy (i.e., they do not mix with each other). Therefore, the barrier function can be constantly maintained even after undergoing the heat treatment.

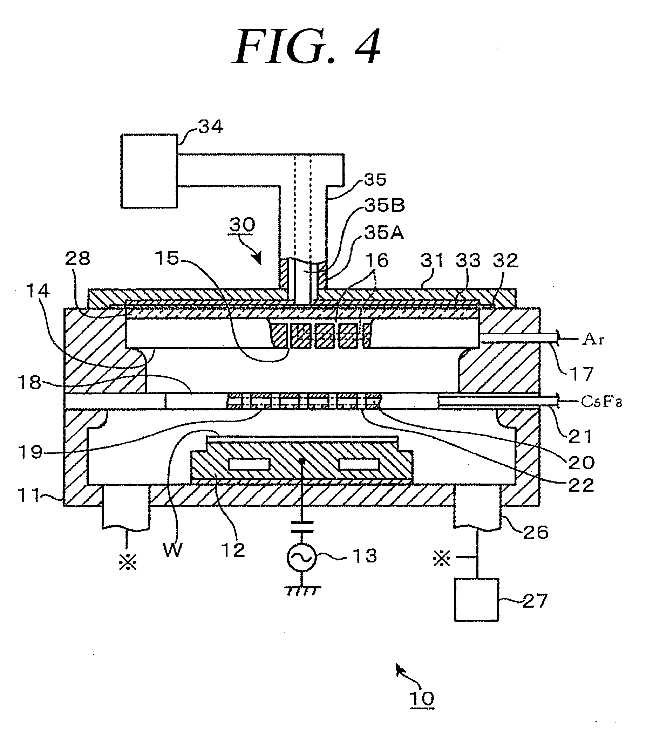

Moreover, the Ti film 74 and the Ta film 75 are approximately 10 nm thin or less, respectively. That is, a whole thickness of the barrier film 78 can be limited to 20 nm or less. Therefore, there is no likelihood of preventing the semiconductor device from becoming thin layered.
Hereinafter, an example of a desirable film forming apparatus for forming the CF film 70 will be briefly explained with reference to Fig. 4. As shown in Fig. 4, a film forming apparatus 10 includes a processing vessel 11 serving as a vacuum chamber, a mounting table 12 provided with a temperature control unit, and a high frequency bias power supply 13 of, e.g., 13.56 MHz connected to the mounting table 12.

At an upper part of the processing vessel 11, a first gas supply unit 14, which has, e.g., an approximately circular shape and made of, e.g., alumina, is installed to face the mounting table 12. A plurality of first gas supply holes 15 is formed in a surface of the first gas supply unit 14, which is facing the mounting table 12. The first gas supply holes 15 are connected to a supply source of a plasma generating gas, for example, a supply source of a rare gas such as an argon (Ar) gas, via a gas flow path 16 and a first gas supply line 17.

Further, installed between the mounting table 12 and the first gas supply unit 14 is a second gas supply unit 18 made of, for example, an approximately circular-shaped conductor. A number of second gas supply holes 19 is formed in a surface of the second gas supply unit 18, which is facing the mounting table 12. Formed inside the second gas supply unit 18 is a gas flow path 20 communicating with the second gas supply holes 19, and the gas flow path 20 is connected to a supply source of a source gas such as a C₅F₈ gas, via a second gas supply line 21.

Furthermore, the second gas supply unit 18 is provided with a multiplicity of openings 22 which vertically pass through the second gas supply unit 18. The openings 22 are not communicated with the second gas supply holes 19 in the second gas supply unit 18, and are formed to allow plasma generated above the second gas supply unit 18 to pass therethrough to reach a space below the second gas supply unit 18. For example, the openings 22 are formed between two adjacent second gas supply holes 19.

In addition, at a bottom part of the processing vessel 11, a ring-shaped opening surrounding the mounting table 12 is installed, and a vacuum exhaust unit 27 is connected to the opening via a gas exhaust pipe 26.

Moreover, an antenna unit 30 is provided above the first gas supply unit 14 via a cover plate 28 formed of a dielectric material such as alumina. The antenna unit 30 includes an antenna body 31 of a circular shape and a planar antenna member (slit plate) 32 buried below the antenna body 31. The planar antenna member 32 is provided with a number of slits (not shown) for generating a circular polarized wave. The antenna body 31 and the planar antenna member 32 are both made of a conductor, and they form a flat hollow circular waveguide.

Further, between the antenna body 31 and the planar antenna member 32, there is disposed a phase delay plate 33 made of a low-loss dielectric material such as, e.g., alumina, silicon oxide or silicon nitride. The phase delay plate 33 serves to shorten a wavelength of a microwave to thereby shorten a wavelength in the circular waveguide.

The antenna unit 30 configured as described above is connected to a microwave generating unit 34, which generates a microwave having a frequency of, for example, 2.45 GHz or 8.4 GHz, via a coaxial waveguide 35. Further, an outer waveguide 35A of the coaxial waveguide 35 is connected to the antenna body 31, and a central conductor 35B thereof is connected to the planar antenna member 32 through an opening formed in the phase delay plate 33.

Hereinafter, a film forming method of the CF film 70, which is performed by using the aforementioned film forming apparatus 10, will be described. First, the wafer W is loaded into the processing vessel 11 to be mounted on the mounting table 12. Then, the inside of the processing vessel 11 is exhausted by using the vacuum exhaust unit 27, and then, for example, the Ar gas and the C₅F₈ gas are supplied into the processing vessel 11 at a preset flow rate. Further, the inside of the processing vessel 11 is set to have a predetermined process pressure, and the wafer W is heated by the temperature control unit provided in the mounting table 12.

Meanwhile, a high frequency wave (microwave) of 2.45 GHz generated from the microwave generating unit 34 is radiated toward a processing space at a lower side thereof via the cover plate 28 and the first gas supply unit 14 and through a non-illustrated slit formed in the planar antenna member 32.

By the microwave, plasma of the Ar gas having high density and uniformity is excited in a space between the first gas supply unit 14 and the second gas supply unit 18. Meanwhile, the C₅F₈ gas, which is released from the second gas supply unit 18 toward the mounting table 12, makes contact with the plasma of the Ar gas, which is flown from an upper side thereof through the openings 22, thereby generating active species. The active species are deposited onto the surface of the wafer W, and the CF film 70 is formed on the barrier film 64. The C₅F₈ gas is used as a source gas for the fluorine-containing carbon film, but not limited thereto, and a CF₄ gas, a C₂F₆ gas, a C₃F₈ gas, a C₃F₉ gas, a C₄F₈ gas or the like may also be used.

Further, in order to form the Ti film 74, as described above, various commonly-known sputtering devices may be used. In general, the sputtering device includes a Ti plate as a metal source for sputtering titanium by a discharge, and allows the Ti film 74 to be formed by depositing titanium particles generated from the Ti plate.

The titanium particles are highly active. Therefore, when deposited onto a surface of the CF film 70, the titanium particles react with elements (carbon and fluorine) in the CF film 70, so that titanium carbide and titanium fluoride are generated. The titanium fluoride (TiF₄) has a high vapor pressure like the tantalum fluoride described above. For this reason, as the generation of the titanium fluoride progresses, incurred is the increase of sheet resistance or a density decrease of the Ti film 74. Meanwhile, the titanium carbide has a low vapor pressure and is stable. The above reaction is progressed by a heat treatment, for example, the above-described annealing process which is performed after the manufacture of the semiconductor device is completed. However, as can be seen from experimental results to be described later, the titanium carbide is selectively generated so that the generation of titanium fluoride is suppressed, thereby allowing the increase of sheet resistance or the density decrease of the Ti film 74 to be suppressed. As a result, the Ti film 74 in accordance with the present embodiment can have a high barrier property against the fluorine. The Ti film 74 is not limited to a film formed by the sputtering, but may be formed by other film forming methods, for example, a method using the above-mentioned film forming apparatus 10.

After the Ti film 74 is formed, the film formation of the Ta film 75 is performed. In order to form the Ta film 75, various commonly-known sputtering devices may be used in the same manner as the Ti film 74.

The manufacturing method of the semiconductor device in accordance with the present invention is not limited to a damascene method, but is applicable to a method in which the Cu wiring 76 is formed first and then the CF film 70 is formed to surround the Cu wiring 76.

### <Explanation of experiments>

In order to examine which element is optimum with respect to the effect of the barrier film against the copper and the fluorine, the experiments as follows were conducted.

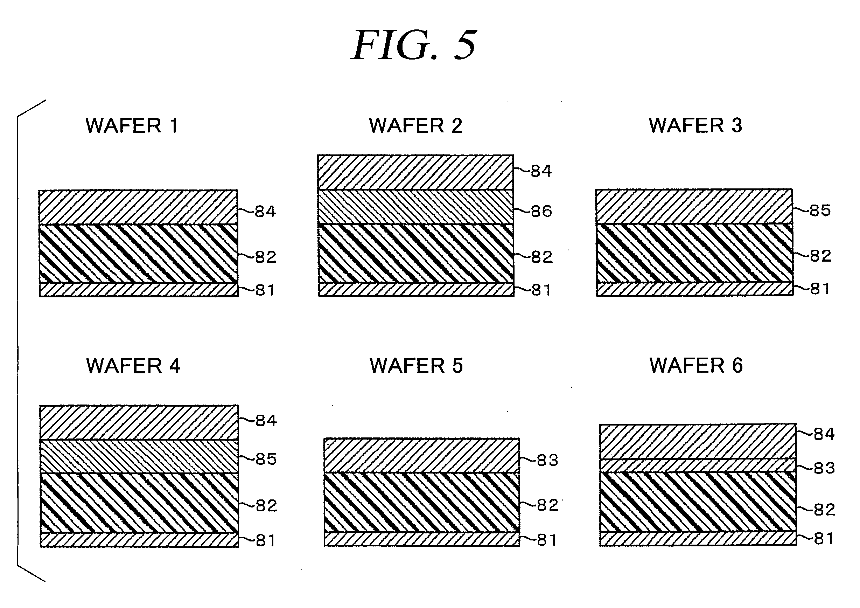

Schematic cross sections of Nos. 1 to 6 wafers (hereinafter, referred to as 'wafers 1 to 6') used in the experiments are illustrated in Fig. 5. All of the wafers 1 to 6 have a common point in that a CF film 82 having a thickness of 150 nm is formed on a Si substrate 81, which is a bare silicon wafer for an experiment, by using the above-mentioned film forming apparatus 10. However, each wafer has a different barrier film, which is shown in Table 1 as follows, formed on the CF film 82.
[Table 1]

**(Table 1)**

| Wafer No. | 1 | 2 | 3 | 4 | 5 | 6 |
|---|---|---|---|---|---|---|
| Element | Ta | Ta | Ni | Ta | Ti | Ta |
| species | | TaN | | Ni | | Ti |
| Film | 8 | 8 | 6 | 8 | 13 | 8 |
| thickness(nm) | | 8 | | 6 | | 3 |

The sputtering device was used for the film formation of each of the element species shown in Table 1. The detailed description of the film forming conditions will be omitted herein. Further, in case that two kinds of films are formed as shown in Table 1 (wafers 2, 4 and 6), a Ta film 84 is laminated thereon.

Further, in the following experiments, a heat treatment was performed on each of the wafers 1 to 6. The condition thereof is as follows.
(Heat treatment condition)
Heat treatment temperature: 400°C
Heat treatment time: 15 minutes
Pressure: 266.7 Pa (2,000 mTorr)
Atmosphere: Ar = 500 sccm

### <Experiment 1: Variation of sheet resistance due to heat treatment>

With respect to each of the wafers 1 to 6 as shown in Fig. 5, a Cu film 87 (not shown) is formed on the metal (Ta, Ni, Ti or the like) of an uppermost layer by the above-mentioned method.

Thereafter, a heat treatment was performed on each of the wafers 1 to 6 under the above-mentioned condition. Then, the wafers 1 to 6 were taken out into an atmospheric atmosphere, and the sheet resistances thereof were measured respectively. The results are shown in Table 2.
[Table 2]

**(Table 2)**

| Wafer No. | 1 | 2 | 3 | 4 | 5 | 6 |
|---|---|---|---|---|---|---|
| Before heat treatment | 47.7 | 122.9 | 89.1 | 47.2 | 170.4 | 37.1 |
| After heat treatment | 300.1 | 150.8 | 80.0 | 44.3 | 362.2 | 48.9 |

According to Table 2, it could be seen that the measured results for the wafers 1 and 5 are undesirable because the sheet resistances thereof are increased greatly due to the heat treatment.

With respect to the wafer 1 in comparison with the wafer 2, it could be derived that it is not desirable to allow the Ta film 84 to make a direct contact with the CF film 82. In case of the wafer 1, it is considered that the fluorine is diffused into the Ta film 84 from the CF film 82 by the heat treatment, so that the tantalum fluoride having a high vapor pressure is generated, whereby the sheet resistance was increased due to the evaporation of the tantalum fluoride.

With respect to the wafer 5 in comparison with the wafer 6, it could be derived that it is not desirable to allow a Ti film 83 to make a direct contact with the Cu film 87. In case of the wafer 5, it is considered that the copper is diffused into the Ti film by the heat treatment and reacts with the fluorine in the CF film 82, whereby a compound having a high sheet resistance is generated.

### <Experiment 2: Variation of X-ray intensity due to heat treatment>

With respect to the wafers 2, 3, 4 and 6, the Cu film 87 was formed in the same manner as Experiment 1.

Thereafter, a heat treatment was performed on each of the wafers under the above-mentioned condition. Then, the X-ray intensity of each metal was measured by an X-ray fluorescence (XRF) analysis, and a ratio of the number of metal atoms in each metal film before and after the heat treatment was obtained. The results are shown in Table 3.
[Table 3]

**(Table 3)**

| Wafer No. | 2 | 3 | 4 | 6 |
|---|---|---|---|---|
| Ta | 0.93 | | 0.95 | 1.0 |
| Ni | | 0.99 | 1.0 | |
| Ti | | | | 1.0 |

According to Table 3, it could be seen that the obtained results for the wafers 2 and 4 are undesirable because the number of atoms of Ta therein is decreasing due to the heat treatment.

A TaN film 86 of the wafer 2 and a Ni film 85 of the wafer 4 transmit the fluorine from the CF film 82 slightly. Therefore, it is considered that the tantalum fluoride is generated from the Ta film 84 and it is evaporated. Further, the measurement results by a transmission electron microscope (TEM) show that there is no change in a whole thickness of the films deposited on the Si substrate 81. Accordingly, it is known that a decrease of the film thickness is not incurred and only elements in the film are left out.

### <Experiment 3: Element analysis>

Subsequently, with respect to the wafers 3 and 6, the Cu film 87 (not shown) was formed on the metal of the uppermost layer in the same manner as the above-mentioned method.

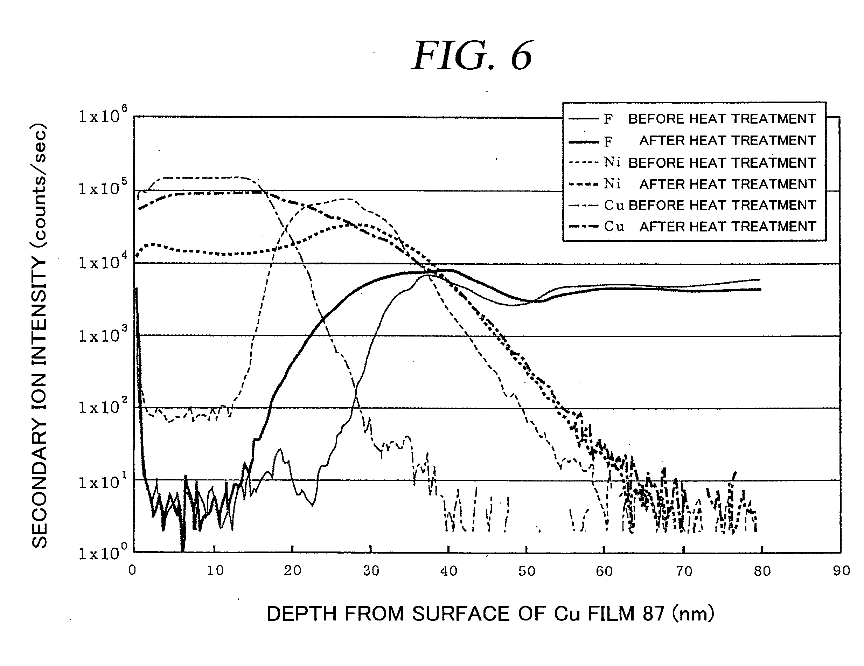

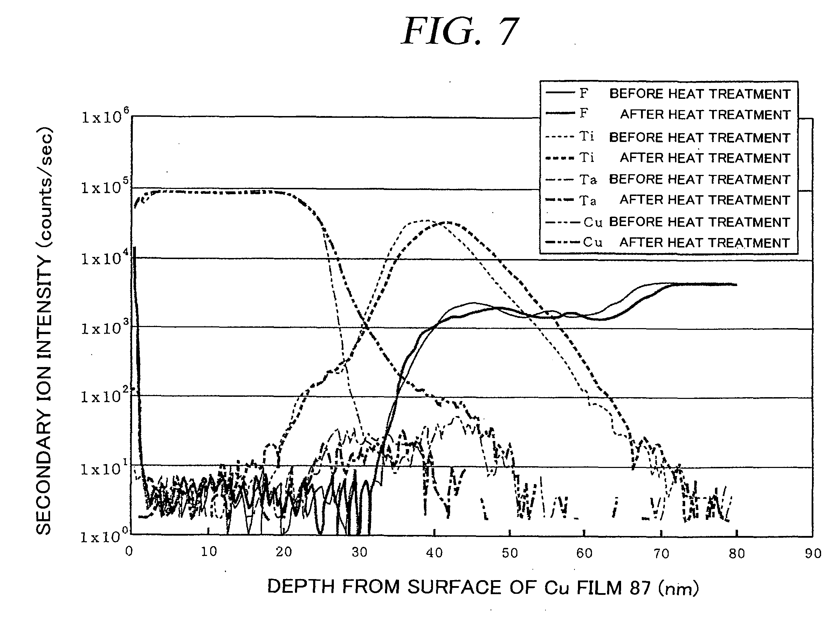

Thereafter, a heat treatment was performed on each of the wafers under the above-mentioned condition. Then, by using a secondary ion mass spectroscopy (SIMS), the amount of each element (Cu, Ta, Ni and F) in the depth direction was measured. The result of element analysis for the wafer 3 before and after the heat treatment is illustrated in Fig. 6. Likewise, the result of element analysis for the wafer 6 before and after the heat treatment is illustrated in Fig. 7.

In view of Fig. 6, peaks of Cu and Ni shown before the heat treatment disappeared after the heat treatment. These two metals seem to be alloyed by the heat treatment. Further, it is acknowledged that the fluorine was diffused into the alloyed metal. Accordingly, it could be seen that the Ni does not have a sufficient barrier property against two elements of Cu and F.

Meanwhile, considering Fig. 7, the secondary ion intensity of each element in the wafer 6 is rarely varied before and after the heat treatment in the depth direction. That is, the diffusion of Cu and F is not incurred, and it could be seen that the barrier film of the wafer 6 is an optimum barrier film.

### <Experiment 4: Bonding energy>

Thereafter, with respect to the wafer 6 showing a good result in each of the above-described experiments, in order to examine how the Ti film 83 in the wafer 6 is constituted, the experiment as follows was carried out. In the present experiment, by using an X-ray photoelectron spectroscopy (XPS) method, bonding energies of a titanium compound with an upper layer of the Ti film 83 (vicinity of the Ta film 84) and with a lower layer of the Ti film 83 (vicinity of the CF film 82) were measured before and after the heat treatment. Further, this experiment was carried out without forming the Cu film 87.

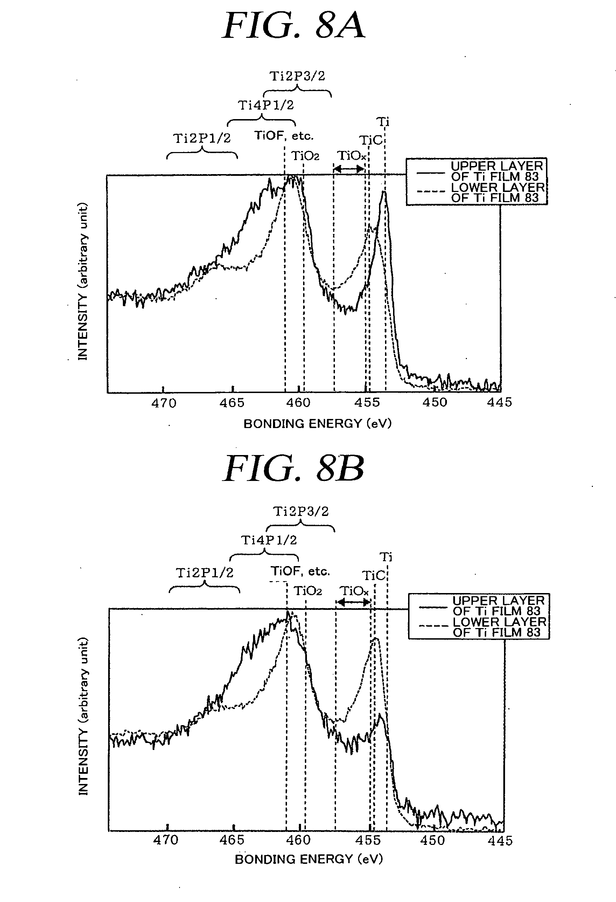

The result of the experiment carried out before the heat treatment is shown in Fig. 8A, and the result of the experiment conducted after the heat treatment is illustrated in Fig. 8B. As shown in Fig. 8A, in the lower layer of the Ti film 83 before performing the heat treatment, peaks corresponding to titanium carbide and titanium oxyfluoride (TiOF) are found. As described above, the reason for this is considered to be that the surface of titanium is activated when the Ti film 83 is formed, thereby reacting with the elements (carbon and fluorine) in the CF film 82. Meanwhile, as shown in Fig. 8B, after the heat treatment, the peak intensity of the titanium carbide increased while there was no change in the peak intensity of the titanium oxyfluoride. From this result, it is assumed that the titanium carbide is selectively generated in the lower layer of the Ti film 83 by the heat treatment.

In addition, before and after the heat treatment, there was no change in the peak intensity of the titanium oxyfluoride in the upper layer of the Ti film 83. From this result, it could be seen that the fluorine in the CF film 82 is diffused over the whole thickness direction of the Ti film 83 during the formation of the Ti film 83, but no diffusion is progressed by the heat treatment. That is, it could be found that Ti film 83 effectively acts as the barrier film against fluorine. In addition, the peak intensity of Ti in the upper layer of the Ti film 83 is decreasing by the heat treatment. The reason for this is considered to be that the titanium in the upper layer was supplied to the lower layer for the titanium carbide which is selectively generated in the lower layer of the Ti film 83.

Further, it could be conjectured that the Ti film 83 making contact with the CF film 82 can, for example, generate titanium fluoride having a high vapor pressure, in the same manner that the Ta film 84 of the wafer 1 generated the tantalum fluoride having a high vapor pressure. However, actually, the titanium carbide is selectively generated in the vicinity of an interface between the CF film 82 and the Ti film 83. That is, Ti and Ta are metals sharing a highly common characteristic in that they both have a high melting point, but the Ta film does not show a sufficient barrier property against the fluorine while the Ti film exhibits a good barrier property against the fluorine.

## Claims

1. A semiconductor device comprising:
a substrate;
an insulating film made of a fluorine-containing carbon film and formed on the substrate;
a copper wiring buried in the insulating film; and
a barrier film formed between the insulating film and the copper wiring,
wherein the barrier film includes:
a first film made of titanium for suppressing a diffusion of fluorine, and
a second film made of tantalum for suppressing a diffusion of copper and formed between the first film and the copper wiring.

2. A manufacturing method of a semiconductor device, the method comprising:
forming an insulating film made of a fluorine-containing carbon film on a substrate;
forming a recess portion in the insulating film;
forming a first film made of titanium in the recess portion;
forming a second film made of tantalum on a surface of the first film; and
forming a wiring made of copper on a surface of the second film.
